# EUROPEAN PATENT APPLICATION

(11) **EP 3 564 986 A1**
(43) Date of publication of application: **06.11.2019**
(21) Application number: 17887450.9
(22) Date of filing: 14.03.2017
(51) Int. Cl.: H01L 21/3213, H01L 31/0224

(54) **METHOD FOR ETCHING ALUMINUM FILM OF AMORPHOUS SILICON SOLAR CELL**

(30) Priority: 30.12.2016 CN 201611257617
(71) Applicant: Eging Photovoltaic Technology Co., Ltd, Changzhou, Jiangsu 213213 (CN)
(72) Inventor: SUN, Tietun, Changzhou Jiangsu 213213 (CN); ZHANG, Kaisheng, Changzhou Jiangsu 213213 (CN); WU, Jiahong, Changzhou Jiangsu 213213 (CN)
(74) Representative: Algemeen Octrooi- en Merkenbureau B.V.
(86) International application number: PCT/CN2017/076575
(87) International publication number: WO 2018/120434

(57) **Abstract**

The present invention belongs to the field of amorphous silicon solar cell production, and particularly relates to a method for etching an aluminum film of an amorphous silicon solar cell. The method comprises adding 2-aminoimidazole, urea, an aqueous leveling agent and a de-foaming agent to de-ionized water, and stirring same evenly; and screen-printing an etching liquid onto an aluminum film of an amorphous silicon solar cell panel, horizontally placing the screen-printed cell panel at room temperature, fully flushing the surface of the aluminum film with clear water, and drying same, and thus completing etching same.

## Description

### TECHNICAL FIELD

The present invention belongs to the field of production of amorphous silicon solar cells, and in particular relates to a method for etching an aluminum film of an amorphous silicon solar cell.

### BACKGROUND

The structure of an amorphous silicon solar cell can be roughly described as follows: firstly, a conductive film (such as SnO₂ or ITO) is deposited on a glass plate, then a layer of amorphous silicon is deposited on the conductive film by chemical vapor deposition, and then a back electrode aluminum film is deposited on the amorphous silicon. In order to prevent short circuit around the cell, it is necessary to etch the aluminum film to form an isolation trench.

In the etching process, it has to ensure sufficient etching and also to avoid the substrate from being eroded. Some existing etchants can easily corrode the substrate while etching the aluminum, and some etchants may remain on the substrate after the aluminum film is removed. These are aspects to be improved in the field of etching an aluminum film of an amorphous silicon solar cell.

### SUMMARY

The present invention is directed to the above problems, and provides a method for etching an aluminum film of an amorphous silicon solar cell:
(1) Preparation of etching liquid
   adding 2-aminoimidazole, urea, aqueous leveling agent and de-foaming agent to de-ionized water at room temperature (25°C, sic passim), and stirring the same to make it even;
   wherein, the 2-aminoimidazole is added to the de-ionized water in an amount of 100 to 400 g/L, the urea is added to the de-ionized water in an amount of 150 to 300 g/L, the aqueous leveling agent is added to the de-ionized water in an amount of 18 to 30 g/L, and the de-foaming agent is added to the de-ionized water in an amount of 10 to 15 g/L;
(2) screen printing through a screen the etching liquid prepared in the step (1) to an aluminum film of an amorphous silicon solar cell panel, horizontally placing the screen-printed cell panel at room temperature, fully rinsing the surface of the aluminum film with clean water, drying the same and completing the etching,
   wherein the screen can be designed into different patterns as needed,
   the screen-printed cell panel is horizontally placed at room temperature for 60 to 120 minutes, and the drying temperature is 70 °C.

The present invention has the beneficial effects in that the present invention finds that the amino group of the 2-aminoimidazole molecular structure combines two amino groups on the urea molecule can synergistically have a strong complexation with aluminum particles at room temperature, which is equivalent to that two amino groups on the 2-aminoimidazole molecule and the two amino groups on the urea molecule simultaneously surround a fine aluminum particle, and the aluminum material can be gradually decomposed and taken away from the aluminum film to finally complete the etching.

Moreover, the etching composition does not cause corrosion to other materials of the panel, has good water solubility, is easy to be washed out, and does not affect subsequent processing of the panel.

### DETAILED DESCRIPTION

### Example 1

(1) Preparation of etching liquid
   200 g/L of 2-aminoimidazole, 220 g/L of urea, 23 g/L of aqueous leveling agent and 12 g/L of de-foaming agent are added to de-ionized water at room temperature (25°C, sic passim), and stirred to make it even.
(2) The etching liquid prepared in the step (1) is screen printed onto an aluminum film of an amorphous silicon solar cell panel through a screen, and the screen-printed cell panel is horizontally placed at room temperature for 100 minutes, and the surface of the aluminum film is fully rinsed with clean water. The rinsed amorphous silicon solar cell panel is dried at 70°C to complete etching. The etched amorphous silicon solar cell panel is observed, and the etched groove is regular and flat.

The rinsing water and the etched liquid rinsed off in the step (2) are collected, and the collected mixed liquid is added with excess hydrochloric acid under heating condition. On the one hand, the acid can promote the full hydrolysis of the urea to cause the surrounded aluminum to be released. On the other hand, flammable gas hydrogen is continuously generated in the process of adding the acid. This also shows that aluminum is actually etched off in this example, and the total amount of aluminum etched off can be calculated according to the amount of gas hydrogen generated. The mixture after reaction with the acid is further detected, and no silicon composition is found in it, which indicates that the etching liquid has no effect on the substrate.

### Comparative example 1

No 2-aminoimidazole is added to the etching liquid, and the other compositions of the etching liquid, the etching operation, and the detection means are all the same as in Example 1.

The rinsing water and the etched liquid rinsed off in the step (2) are collected, and the collected mixed liquid is added with excess hydrochloric acid under heating condition. No flammable gas is generated, indicating that the composition of the etching liquid fails to encapsulate and etch the aluminum. The etched amorphous silicon solar cell panel is observed, and no obvious etched signs.

### Comparative example 2

No urea is added to the etching liquid, and the other compositions of the etching liquid, the etching operation, and the detection means are all the same as in Example 1.

The rinsing water and the etched liquid rinsed off in the step (2) are collected, and the collected mixed liquid is added with excess hydrochloric acid under heating condition. No gas is generated, indicating that the composition of the etching liquid fails to encapsulate and etch the aluminum. The etched amorphous silicon solar cell panel is observed, and no obvious etched signs.

## Claims

1. A method for etching an aluminum film of an amorphous silicon solar cell, **characterized in that**, the method comprises:
step 1 of preparing an etching liquid: adding 2-aminoimidazole, urea, aqueous leveling agent and de-foaming agent to de-ionized water at room temperature, and stirring same to make the same even; and
step 2: screen printing through a screen the etching liquid prepared in the step 1 to an aluminum film of an amorphous silicon solar cell panel, horizontally placing the screen-printed cell panel at room temperature, fully rinsing the surface of the aluminum film with clean water, drying same and completing the etching.

2. The method for etching an aluminum film of an amorphous silicon solar cell according to claim 1, wherein in the step 1, the 2-aminoimidazole is added to the de-ionized water in an amount of 100 to 400 g/L.

3. The method for etching an aluminum film of an amorphous silicon solar cell according to claim 1, wherein in the step 1, the urea is added to the de-ionized water in an amount of 150 to 300 g/L.

4. The method for etching an aluminum film of an amorphous silicon solar cell according to claim 1, wherein in the step 1, the aqueous leveling agent is added to the de-ionized water in an amount of 18 to 30 g/L.

5. The method for etching an aluminum film of an amorphous silicon solar cell according to claim 1, wherein in the step 1, the de-foaming agent is added to the de-ionized water in an amount of 10 to 15 g/L.

6. The method for etching an aluminum film of an amorphous silicon solar cell according to claim 1, wherein in the step 2, the screen-printed cell panel is horizontally placed at room temperature for 60 to 120 minutes.

7. The method for etching an aluminum film of an amorphous silicon solar cell according to claim 1, wherein in the step 2, the drying is performed at a temperature of 70 °C.
